# EUROPÄISCHE PATENTSCHRIFT

(11) **EP 2 537 170 B1**
(45) Veröffentlichungstag und Bekanntmachung des Hinweises auf die Patenterteilung: **25.02.2015**
(21) Anmeldenummer: 10706520.3
(22) Anmeldetag: 20.02.2010
(51) Int. Cl.: H01H 9/06, H01H 36/00, A01D 69/02, H03K 17/96

(54) **ELEKTRISCH BETREIBBARES GARTENGERÄT**
ELECTRICALLY OPERABLE GARDEN DEVICE
APPAREIL DE JARDINAGE COMMANDÉ ÉLECTRIQUEMENT

(43) Veröffentlichungstag der Anmeldung: 26.12.2012
(73) Patentinhaber: HUSQVARNA AB, 561 82 Huskvarna (SE)
(72) Erfinder: HÄNSSLER ,Gerd, 88471 Laupheim (DE)
(74) Vertreter: Finkele, Rolf
(86) Internationale Anmeldenummer: PCT/EP2010/001073
(87) Internationale Veröffentlichungsnummer: WO 2011/100997

(56) Entgegenhaltungen:
- EP-A1- 1 440 771
- DE-A1- 2 617 460
- US-A1- 2004 135 537

## Beschreibung

Die Erfindung betrifft ein elektrisch betreibbares Gartengerät mit einer Schalteranordnung, insbesondere für den Betrieb im Freien.

Elektrisch betreibbare Gartengeräte erfordern durch die Benutzung im Freien besondere Maßnahmen zum Schutz gegen Schmutz und insbesondere gegen Feuchtigkeit. Insbesondere Schalteranordnungen, welche durch den Benutzer betätigbar sind, erfordern besondere abdichtende Maßnahmen, wie z. B. die Verwendung von in sich dichten Schaltern und deren abgedichtete Anordnung in einem Gehäusedurchbruch oder Anordnung eines Schalters hinter einer einen Gehäusedurchbruch abgedichtet überspannenden flexiblen Membran. Diese Anordnungen sind zum einen durch die Mehrzahl von Bauteilen störanfällig und in der Herstellung teuer und zum anderen an abdichtenden Fugen, z. B. zu den Gehäusedurchbrüchen anfällig für Undichtigkeiten.

In der deutschen Offenlegungsschrift DE 26 17 460 A1 wird ein Gartengerät beschrieben, an welches Sensorschalter als ein elektrisch gefahrloses Bedienmittel abgebracht sind. Auch soll mittels der Sensorschalter verhindert werden, dass das Gartengerät bei zufälliger und unbeabsichtigter Bedienung eingeschaltet oder ausgeschaltet wird. Die Sensorelemente sind derart im Sinne von Totmannschaltern am Gerät angebracht, dass sichergestellt werden kann, dass sich die Hände des Gerätenutzers beim Betrieb des Gerätes an sicherer Position am Gerät befinden. In den Fällen, dass an einem einzelnen Gartengerät zwei Sensorelemente angebracht sind, sind diese über eine logische UND-Verknüpfung miteinander verbunden, um hierdurch zu gewährleisten, dass sich beide Hände des Bedieners an einer sicheren Position am Gerät befinden. Einzige Ausnahme von der Ausbildung des Sensors als Totmannschalter bildet ein an einer Unterseite einer Grasschere angebrachtes, als Näherungssensor fungierendes Sensorelement. Doch auch hiermit soll nur sichergestellt werden, dass sich die Grasschere im Betrieb bereits in einer Position knapp über dem Boden befindet, so dass Schneiden in die freie Hand des Bedieners vermieden wird.

Der Erfindung liegt die Aufgabe zugrunde, ein elektrisch betreibbares Gerät mit einer Schalteranordnung anzugeben, welche kostengünstig und zuverlässig ist.

Die Erfindung ist im unabhängigen Anspruch beschrieben. Die abhängigen Ansprüche enthalten vorteilhafte Ausgestaltungen und Weiterbildungen der Erfindung.

Die Ausbildung eines Sensorelements zur Erkennung eines an die Außenseite der Gehäusefläche angelegten Gegenelements durch die Sensoranordnung ermöglicht den Einsatz besonders vorteilhafter einfacher Ausführungen von Sensorelementen, welche mit einer Sensorelektronik zusammenwirken, um einen Schaltvorgang auszulösen. Die Ausbildung eines Sensorelements frei von für die Auflösung eines Schaltvorgangs relativ zueinander bewegbaren mechanischen Bauteilen vermeidet den Verschleiß solcher Bauteile und ermöglicht besonders kostengünstige Sensorelemente.

Das Sensorelement ist auf eine bestimmte Art eines Gegenelements selektiv abgestimmt und reagiert daher nicht auf beliebige Arten von Gegenelementen an der Außenseite der Gehäusefläche, wodurch die Gefahr von unbeabsichtigten Schaltvorgängen weitgehend unterbunden werden kann, wofür das von dem Sensorelement abgeleitete Sensorsignal einer verifizierenden Signalverarbeitung, z. B. in einem Mikroprozessor, unterzogen werden kann. Für die berührungslos erkennende Sensoranordnung sind an sich unterschiedliche Ausführungen bekannt, insbesondere auch solche mit Magnetanordnungen oder der Rückstrahlung von Wellensignalen. Das Gegenelement kann beispielsweise magnetisch sein und z. B. als weichmagnetisches Gegenelement mit einer Spule als Sensorelement oder als permanentmagnetisches Gegenelement mit einem Hall-Sensor zusammenwirken. In anderer vorteilhafter Ausführung kann die Sensoranordnung zur Auswertung des Widerstands eines das Sensorelement und das Gegenelement vorzugsweise in Serienschaltung einschließenden Stromkreises ausgebildet, wofür insbesondere Strom und/oder Spannung in einem solchen Stromkreis gemessen werden kann. In bevorzugter Ausführung ist das Sensorelement zur kapazitiven Kopplung mit einem Gegenelement ausgebildet. Das Gegenelement kann hierfür metallisch elektrisch leitend ausgeführt sein. Vorzugsweise ist das wenigstens eine Sensorelement auf die kapazitive Kopplung mit einem Gegenelement, vorzugsweise mit einem Finger eines Benutzers abgestimmt und enthält hierfür vorteilhafterweise eine zur Gehäusefläche vorzugsweise parallel angeordnete elektrische Leiterfläche. Die Sensoranordnung nutzt dabei die wenn auch geringe elektrische Leitfähigkeit des Benutzerfingers aus. Sensorelektronik-Schaltungen zur Auswertung veränderlicher Kapazitäten von Sensorelementen sind bekannt.

Die Leiterfläche kann dabei, insbesondere zusammen mit dem Elementträger, einen Teil der Außenseite der Gehäusefläche bilden. Die Leiterfläche kann, insbesondere für kapazitive Auswertung, mit einer Isolierschicht und/oder einer isolierenden Folie überdeckt sein. Das wenigstens eine Sensorelement enthält vorteilhafterweise wenigstens eine Leiterfläche, welche zur Gehäusefläche, an der es angeordnet ist, vorzugsweise parallel verläuft. Die Gehäusefläche kann im Bereich des wenigstens einen Sensorelements einen Gehäusedurchbruch aufweisen, in welchem das Sensorelement angeordnet ist. Das Sensorelement ist dabei vorteilhafterweise auf einem Elementträger angeordnet, welcher den Gehäusedurchbruch verschließt und z. B. mit diesem verklebt ist.

Die wenigstens eine Leiterfläche der Sensoranordnung verläuft vorteilhafterweise parallel zu der Gehäusefläche, an der sie angeordnet ist. Vorteilhafterweise kann die Sensoranordnung mehrere elektrisch gegeneinander isolierte Leiterflächen als Sensorelemente enthalten, wobei auch mehrere getrennte Leiterflächen ein und derselben Schaltfunktion zugeordnet sein und kombiniert ausgewertet werden können.

Beim Anlegen eines Benutzerfingers an die Außenseite der Gehäusefläche im Bereich der wenigstens einen Leiterfläche als Sensorelement erhöht sich die Kapazität der Leiterfläche, was in einer Sensorelektronik der Sensoranordnung erkannt und ausgewertet wird, um einen Schaltvorgang in der Schaltanordnung auszulösen.

Zur Vermeidung von z. B. durch auf der Gehäusefläche auftretendem Wasser verursachten Falsch-Schaltvorgängen ist eine Auswertung des Zeitverlaufs der Kapazitätsänderung und eine Auswertung der geometrischen Verteilung von Kapazitäten mehrerer benachbarter Leiterflächen in der Sensorelektronik und/oder der Schaltanordnungen vorgesehen.

Der Einsatz eines Sensorelements hinter einer geschlossenen Gehäusefläche vereinfacht die Herstellung des Geräts weiter und schließt durch die Schaltanordnung bedingte Undichtigkeiten praktisch aus. Der Wegfall eines Durchbruchs durch eine dem Benutzer zuweisende Gehäusefläche vereinfacht in vielen Fällen von Kunststoff-Spritzgussgehäusen das Spritzgusswerkzeug und das Einsetzen eines Schalterelements und/oder einer flexiblen Folie in einen solchen Durchbruch mit den Abdichtungsproblemen entfällt.

Zur Aktivierung eines Schaltvorgangs der Schaltanordnung legt der Benutzer ein Gegenelement, vorzugsweise einen Finger an die Außenfläche der ihm zuweisenden Gehäusefläche und die hinter der Gehäusefläche dem Benutzer abgewandt angeordnete Sensoranordnung erkennt berührungslos durch die geschlossene Gehäusefläche hindurch das Anlegen des Gegenelements und erzeugt ein entsprechendes Sensorsignal, welches den gewünschten Schaltvorgang in der Schaltanordnung auslöst. Unter berührungslos sei verstanden, dass das Gegenelement nicht unmittelbar ein Sensorelement der Sensoranordnung berührt.

Die Gehäusewand ist vorteilhafterweise in dem Bereich des Sensorelements bzw. der Anlagefläche für das Gegenelement starr ausgeführt und gibt z. B. einem Fingerdruck des Benutzers nicht nach. In anderer Ausführungsform kann die Gehäusefläche im Bereich des Sensorelements auch einem Fingerdruck elastisch nachgebend ausgeführt sein, beispielsweise durch eine verringerte Wandstärke und/oder eine besondere Ausführung einer Tastenfläche oder dgl.. Die Gehäusefläche besteht in vorteilhafter Ausführung aus einem elektrisch nichtleitenden Material, insbesondere aus Kunststoff.

Nachfolgend ist, ohne Beschränkung der Allgemeinheit, von einer kapazitiv messenden Sensoranordnung mit einem auf einen Finger eines Benutzers als Gegenelement abgestimmten Sensorelement und der Anordnung des Sensorelements hinter einer geschlossenen isolierenden Gehäusefläche ausgegangen, soweit nicht explizit oder offensichtlich andere Ausführungen gemeint sind.

Die wenigstens eine Leiterfläche kann z. B. als eine metallische oder metallisierte Federzunge ausgeführt sein, welche dabei vorteilhafterweise unter elastischer Verspannung an der Innenwand der Gehäusefläche anliegen kann. Insbesondere bei mehreren, elektrisch gegeneinander isoliert angeordneten Leiterflächen als Sensorelementen hinter einer ebenen Gehäusefläche können die Leiterflächen auf einen gemeinsamen Träger, insbesondere einer Schaltungsplatine mit anderen elektrischen Elementen, angeordnet und vorzugsweise in gedruckter Schaltungstechnik ausgeführt sein.

Als Schaltvorgang in der Schaltanordnung kann prinzipiell jede elektrische Zustandsumschaltung, neben Ein- und Ausschaltvorgängen insbesondere auch Anzeigevorgänge, Änderungen von Speicherinhalten und dgl. verstanden sein. Zur für den Benutzer eindeutigen flächigen Zuordnung von Bereichen der Gehäusefläche zu einem oder mehreren Schaltvorgängen kann die dem Benutzer zuweisende Außenseite der Gehäusefläche flächig strukturiert, insbesondere bedruckt sein. Die Gehäusefläche kann auch transparent ausgeführt sein, so dass der Benutzer eine flächige Strukturierung z. B. eines oder mehrerer Sensorelemente durch die Gehäusefläche hindurch erkennen kann.

Die Gehäusefläche kann vorteilhafterweise im wesentlichen eben ausgeführt sein. Die Gehäusefläche kann in vorteilhafter Ausführung erhabene und/oder vertiefte Strukturen, beispielsweise ähnlich einem Tastenfeld, für eine genaue Positionierung eines Benutzerfingers und/oder als tastbare Positionierhilfe aufweisen.

In vorteilhafter Ausführung kann eine Sensoranordnung zur Erkennung einer Bewegung eines an die Außenseite der Gehäusefläche angelegten Benutzerfingers entlang der Gehäusefläche und zur Auswertung einer solchen Bewegung zur Ableitung eines Schaltvorgangs ausgebildet sein. Elektronikeinrichtungen zur Erkennung und Auswertung solcher Bewegungen sind z. B. von berührungsempfindlichen Bildschirmen oder von sogenannten Touch-Pads an sich bekannt. Ein Sensorelement kann hierfür vorteilhafterweise mehrere in Richtung der zu erkennenden Bewegungsrichtung aufeinander folgend angeordnete Sensor-Teilelemente aufweisen, wobei die mehreren Teilelemente vorzugsweise in einer Längsrichtung eines langgestreckten Sensorelements aufeinanderfolgend angeordnet sind.

In vorteilhafter Ausführung eines Geräts mit mehreren veränderlich einstellbaren Betriebsparametern können wenigstens zwei Sensorelemente vorgesehen sein. In besonders vorteilhafter Ausführung kann dabei ein erstes Sensorelement zur Auswahl eines der Betriebsparameter oder auch einer Gruppe von Betriebsparametern ausgebildet sein und das zweite Sensorelement kann zur Veränderung der Einstellung eines ausgewählten Betriebsparameters dienen. Die veränderliche Einstellung mehrerer Betriebsparameter ist insbesondere von Vorteil bei einem Gerät nach Art eines Bewässerungscomputers zur Einstellung von Bewässerungsdauer, Startzeit der Bewässerung, Wiederholzeit und weiteren an sich bekannten veränderlichen Daten der Steuerung eines oder mehrerer Bewässerungsgeräte.

Bei Vorliegen von wenigstens zwei Sensoranordnungen mit getrennten Sensorelementen können die Sensorelemente in einer vorteilhaften Ausführung an verschiedenen Seiten einer Anzeigefläche angeordnet sein, vorzugsweise an zwei zueinander orthogonalen Seiten einer rechteckigen Anzeigefläche. Vorteilhafterweise kann eine Mehrzahl von Anzeigeelementen in zwei Dimensionen flächig über die Anzeigefläche verteilt angeordnet sein, wobei in besonders vorteilhafter Ausführung eine Anordnung der Anzeigeelemente in mehreren parallelen Reihen vorgesehen ist, wobei vorzugsweise getrennte Seiten der Anzeige von verschiedenen Betriebsparametern zugeordnet sind. Dabei kann vorteilhafterweise mit einer ersten Sensoranordnung an einer ersten Seite der Anzeigefläche eine der mehreren Reihen entsprechend einem von mehreren Betriebsparametern ausgewählt werden und mit der zweiten Sensoranordnung an einer zweiten Seite der Anzeigefläche kann ein veränderlich abspeicherbarer Wert des ausgewählten Betriebsparameters eingestellt werden.

Die Erfindung ist nachfolgend anhand bevorzugter Ausführungsbeispiele unter Bezugnahme auf die Abbildungen noch eingehend veranschaulicht. Dabei zeigt:
- Fig. 1: ein Ausführung mit Sensorelementen hinter einer Gehäuswand,
- Fig. 2: eine Anordnung mit einem in eine Gehäuseöffnung eingesetzten Träger für Sensorelemente,
- Fig. 3: ein Leiterflächenmuster als Sensorelemente auf einer Schaltungsplatine.

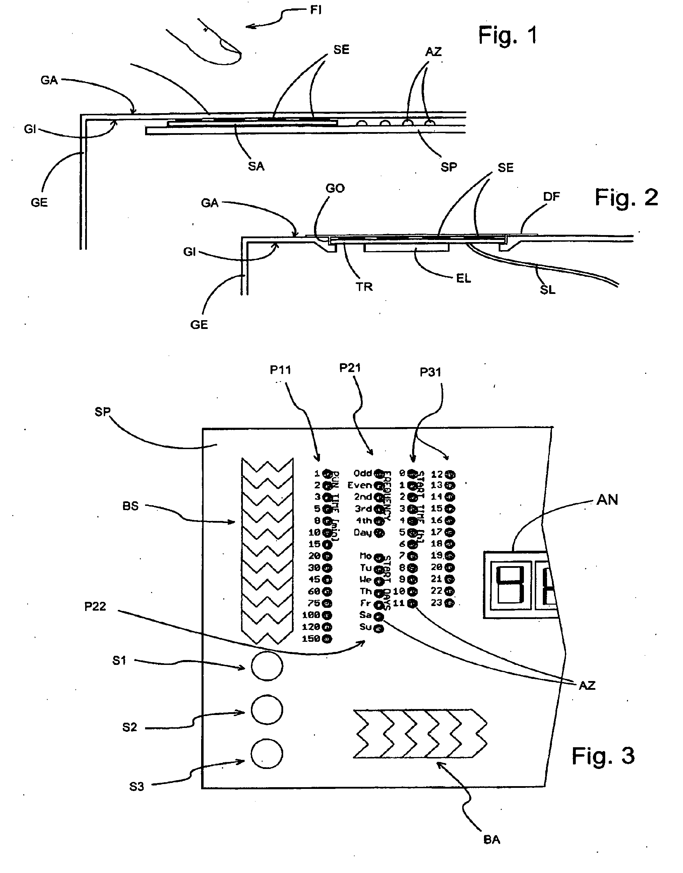

Fig. 1 zeigt in geschnittener Ansicht einen Ausschnitt aus einem Gerätegehäuse GE. Eine als eben angenommene Gehäusefläche GF des Gerätegehäuses besitzt eine außen liegende Seite GA und einen innen liegende Seite GE.

Im Inneren des Gerätegehäuses GE dem Benutzer abgewandt ist hinter der Gehäusefläche GF eine Sensoranordnung SA mit mehreren Sensorelementen SE angeordnet. Die Sensorelemente SE sind in einer im wesentlichen parallel zur Innenseite der Gehäusefläche GF verlaufenden Elementfläche angeordnet und liegen vorteilhafterweise in geringer Distanz von oder unmittelbar an der Innenseite GI der Gehäusefläche GF an. Die Sensorelemente können auch gegen die Innenseite der Gehäusefläche GF verspannt sein. Die Sensorelement SE können vorteilhafterweise auf einer Schaltungsplatine SP angeordnet sein und dabei eine eigenständige, flache, auf der Schaltungsplatine SP gehaltene Elementanordnung bilden oder als Leiterflächen direkt auf der Schaltungsplatine SP ausgeführt sein. Auf der Schaltungsplatine können zusätzlich Anzeigeelemente AZ beispielsweise in Form von Leuchtdioden vorgesehen sein, wobei bei einer solchen Anordnung davon ausgegangen ist, dass die Gehäusefläche GF transparent ausgeführt ist.

Die Gehäusefläche GF besteht vorteilhafterweise aus einem nicht leitenden Material, insbesondere einem Kunststoff.

Zu der Sensoranordnung SA gehört auch noch eine Sensorelektronik zur Bestimmung und Auswertung von über die Sensorelemente ermittelten Sensorsignalen. Die Sensorelektronik kann auf der Schaltungsplatine SP oder getrennt von dieser angeordnet und über Leitungen mit den Sensorelementen verbunden sein.

Die Sensorelemente SE sind vorteilhafterweise als elektrisch leitende Flächen ausgeführt und die Sensoranordnung ist vorteilhafterweise auf dem Prinzip der Messung von Änderungen der Kapazitäten der Leiterflächen aufgebaut. Eine Änderung der Kapazität der als Sensorelemente dienenden Leiterflächen ergibt sich beispielsweise, wenn ein Benutzer einen Finger FI an die Außenseite GA der Gehäusefläche GF gegenüber einem Sensorelement legt. Hierbei wird die Kapazität des von dem Finger abgedeckten Sensorelements messbar erhöht, so dass das Anlegen eines Benutzerfingers an die Außenseite GA der Gehäusefläche GF in der Sensorelektronik detektiert werden kann.

Vorteilhafterweise kann mit der Anordnung der Sensorelemente SE auf der dem Benutzer abgewandten Seite der Gehäusefläche GF und der berührungslosen Erfassung des Anlegen eines Benutzerfingers an die Außenseite GA der Gehäusefläche durch die Sensoranordnung ein Schaltvorgang in einer Schaltanordnung des Geräts durch eine ohne Unterbrechung durchgehende Gehäusefläche GF bewirkt werden. Die Sensoranordnung erfordert daher keinerlei Durchbrüche durch das Gehäuse, welche Anlaß zu Undichtigkeiten sein könnten.

Für die Ausführung und Auswertung von kapazitiv arbeitenden Sensoranordnungen sind Sensor-Elektronikschaltungen, welche für das Zusammenwirken mit Leiterflächen als Kapazitätselektroden ausgebildet sind, allgemein bekannt und verfügbar und daher an dieser Stelle nicht näher beschrieben. Die Auswertung von Kapazitätsveränderungen kann insbesondere sowohl das quasi statische Anlegen eines Fingers an eine bestimmte Stelle der Gehäusefläche gegenüber einem oder mehreren Sensorelementen als auch das kurze Antippen oder das bewußte Bewegen eines an die Gehäusefläche angelegten Fingers auf der Gehäusefläche umfassen, was an sich von den sogenannten Touch-Pads hinlänglich bekannt ist.

In Fig. 2 ist in zu Fig. 1 analoger Ausschnittdarstellung eine Ausführung skizziert, bei welcher in der dem Benutzer zugewandten Gehäusefläche eine Aussparung GO vorgesehen, in welche ein Träger TR mit einer Mehrzahl von Sensorelementen SE eingesetzt ist. Der Träger TR kann insbesondere am Rand der Öffnung mit der Gehäusefläche verklebt sein. Die Verklebung kann vorteilhafterweise wasserdicht ausgeführt sein. Die vorteilhafterweise metallischen Leiterflächen der Sensorelemente sind für eine kapazitiv arbeitende Sensoranordnung vorzugsweise durch eine elektrisch isolierende Schicht überdeckt, wobei eine solche isolierende Schicht fest auf dem Träger TR und den Sensorelementen verbunden und/oder durch eine die Sensoranordnung auf der Außenseite GA der Gehäusefläche abdeckende Folie DF gebildet sein kann. Im Beispiel der Fig..2 ist eine Sensorelektronik EL zumindest zum Teil mit dem Elementträger TR verbunden und Sensorsignale können über eine Signalleitung SL der Schaltanordnung und/oder gegebenenfalls weiteren Komponenten der Sensorelektronik zugeleitet werden.

Die Erfindung ist besonders vorteilhaft bei Geräten, welche im Zusammenhang mit der Gartenbewässerung stehen und bei denen daher verstärkt mit der Beaufschlagung von Gehäuseflächen durch Wasser gerechnet werden muss. Insbesondere gilt dies für Steuergeräte zur zeitgesteuerten Bewässerung, bei welchen eine Mehrzahl von Parametern einstellbar sind. Ein Beispiel einer Sensoranordnung für ein solches Bewässerungs-Steuergerät, allgemein als auch Bewässerungscomputer bezeichnet, ist nachfolgend anhand der Fig. 3 noch erläutert.

Fig. 3 zeigt einen Ausschnitt aus einer Schaltungsplatine, auf welcher eine Mehrzahl von Sensorelementen BA, BS, S1, S2, S3 in Form von Leiterflächen sowie in mehreren parallelen Reihen gruppiert eine Vielzahl von Anzeigeelementen AZ, insbesondere Leuchtdioden angeordnet sind. Die Diodenreihen sind zur Veranschaulichung beschriftet. Im Realfall kann die Beschriftung, soweit durch die Gehäusefläche erkennbar, auf der Platine vorgesehen sein oder auf die Gehäusefläche außen aufgedruckt sein.

Die Sensorelemente sind durch ein erstes Elementband BA mit mehreren in Längsrichtung x des Elementbandes BA aufeinander folgenden Teil-Sensorelementen, ein zweites Elementband BS mit in Längsrichtung y des zweiten Elementbandes aufeinanderfolgenden Teilflächen als Teil-Sensorelementen sowie drei einzelne, im Beispielsfall kreisförmige Sensorelementen S1, S2, S3 gegeben. Bei den Elementbändern BA und BS sind die einzelnen Teilelemente eng beieinander liegend, aber elektrisch voneinander getrennt. Die gemeinsame Auswertung der Teil-Sensorsignale der einzelnen Teilflächen erlaubt in an sich bekannter Weise das Auswerten einer Bewegungsrichtung eines entlang des Bandes in der einen oder der anderen Richtung bewegten Fingers an der Außenseite GA der Gehäusefläche GF.

Beispielsweise kann das Elementband BA als Sensorelement dazu dienen, eine der mehreren Diodenreihen für eine weitere Eingabe in den Bewässerungscomputer auszuwählen und nach Auswahl einer Reihe kann mit dem weiteren Elementband BS der oder die in der jeweiligen Reihe von Anzeige-elementen dargestellte Wert des jeweiligen Betriebsparameters verändert werden.

Im skizzierten Beispiel sind in einer ersten Elementreihe eine erste Gruppe P11 von Dioden vorgesehen, um die in Minuten angezeigte Beregnungsdauer einer Regneranordnung, welche über ein von dem Bewässerungscomputer angesteuertes elektromagnetisches Ventil mit Wasser beaufschlagbar ist, anzuzeigen. Wird mittels des ersten Elementbands BA die erste Reihe von Anzeigeelementen ausgewählt, um die Beregnungsdauer zu verstellen, kann mit dem zweiten Elementband BS der eingestellte, in Minuten angezeigte Wert verändert werden.

In einer zweiten Reihe kann beispielsweise ausgewählt werden, ob tägliche oder in welchen Tagesabständen beregnet werden soll, was einer Gruppe P21 von Anzeigeelementen zugeordnet ist. Eine zweite Gruppe von Anzeigeelementen P22 in derselben Reihe wie die Anzeigeelemente P21 kann beispielsweise dafür vorgesehen sein, einen Wochentag als Starttag festzulegen. Eine Gruppe P31 als Doppelreihe von Anzeigeelementen dient z. B. zur Einstellung einer Uhrzeit für den Start einer Bewässerung. Weitere Parameter, welchen weitere Reihen zugeordnet sein können, sind von Bewässerungscomputern an sich bekannt. Als Anzeigelement kann auch eine zur veränderlichen Darstellung unterschiedlicher Zeichen ausgebildete, beispielsweise alphanumerische Anzeige AN, z.B. in LCD-Technik vorgesehen sein.

Über die Sensorelemente S1, S2, S3 können beispielsweise Befehle zur Einspeicherung eines eingestellten Parameterwerts, zum Löschen eines Parameterwerts, zum Rücksetzen aller Eingaben, zum Ein-/Ausschalten des Bewässerungscomputers usw. ausgelöst werden.

Durch die Anordnung der Sensorbänder BA und BS mit ihren jeweiligen Längsrichtungen an orthogonalen Seiten eines Anzeigefeldes wird die Bedienung über die Sensorflächen intuitiv einfach ausgestaltet.

## Patentansprüche

1. Elektrisch betreibbares Gartengerät mit einer manuell durch einen Benutzer betätigbaren Schaltanordnung,
bei welchem die Schaltanordnung eine Sensoranordnung (SA) umfasst, welche wenigstens ein an einer Gehäusefläche (GF) angeordnetes Sensorelement (SE) enthält, wobei das Sensorelement zur Erkennung eines an die Außenseite (GA) der Gehäusefläche dem Sensorelement gegenüber angelegten Gegenelements, auf welches das Sensorelement abgestimmt ist, ausgebildet ist und durch Anlegen eines Gegenelements an die Außenseite der Gehäusefläche ein Schaltvorgang in der Schaltanordnung auslösbar ist,
wobei das Sensorelement frei von zur Auslösung eines Schaltvorgangs bewegbaren mechanischen Bauteilen ist,
wobei an der Gehäusefläche wenigstens zwei kapazitiv messende Sensorelemente vorgesehen sind, welche jeweils zugeordnete Leiterflächen aufweisen,
**dadurch gekennzeichnet,**
**dass** die wenigstens zwei Sensorelemente zur Auswahl mehrerer veränderlich einstellbarer Betriebsparameter des Gartengerätes ausgeführt sind,
**dass** die Sensoranordnung zur gemeinsamen Auswertung von Sensorsignalen mehrerer Leiterflächen ausgebildet ist,
wozu die Schaltanordnung oder eine Sensorelektronik ausgebildet ist zur Auswertung des Zeitverlaufs der Kapazitätsänderung und zur Auswertung der geometrischen Verteilung von Kapazitäten der mehreren benachbarten Leiterflächen.

2. Gerät nach Anspruch 1, **dadurch gekennzeichnet, dass** das Sensorelement auf ein elektrisch leitendes oder ein magnetisches Gegenelement abgestimmt ist.

3. Gerät nach Anspruch 1, **dadurch gekennzeichnet, dass** das Sensorelement auf einen Finger eines Benutzers als Gegenelement abgestimmt ist und die elektrische Leitfähigkeit des Fingers.

4. Gerät nach einem der Ansprüche 1 bis 3, **dadurch gekennzeichnet, dass** die Sensoranordnung wenigstens eine im wesentlichen flächig ebene Leiterfläche als Sensorelement enthält.

5. Gerät nach Anspruch 4, **dadurch gekennzeichnet, dass** die Sensoranordnung eine zur Auswertung der Kapazität der Leiterfläche ausgebildete Sensorelektronik enthält.

6. Gerät nach Anspruch 4, **dadurch gekennzeichnet, dass** die Sensoranordnung eine zur Auswertung des Widerstands des Sensorelements ausgebildete Sensorelektronik enthält.

7. Gerät nach einem der Ansprüche 4 bis 6, **dadurch gekennzeichnet, dass** mehrere Leiterflächen als Sensorelemente nebeneinander angeordnet sind und die Sensorelektronik die Sensorsignale benachbarter Leiterflächen gemeinsam auswertet.

8. Gerät nach Anspruch 7, **dadurch gekennzeichnet, dass** der gegenseitige Abstand benachbarter Leiterflächen kleiner ist als die Querabmessung der Leiterflächen.

9. Gerät nach einem der Ansprüche 1 bis 8, **dadurch gekennzeichnet, dass** das wenigstens eine Sensorelement auf einer Schaltungsplatine angeordnet ist.

10. Gerät nach einem der Ansprüche 1 bis 9, **dadurch gekennzeichnet, dass** wenigstens eine Sensorelement hinter einer dem Benutzer zugewandten geschlossenen Gehäusefläche angeordnet ist.

11. Gerät nach Anspruch 10, **dadurch gekennzeichnet, dass** die Gehäusefläche aus isolierendem Material besteht.

12. Gerät nach einem der Ansprüche 10 oder 11, **dadurch gekennzeichnet, dass** das wenigstens eine Sensorelement an die Innenseite der Gehäusefläche angedrückt ist.

13. Gerät nach einem der Ansprüche 1 bis 9, **dadurch gekennzeichnet, dass** das Sensorelement im Bereich eines Gehäusedurchbruchs angeordnet ist.

14. Gerät nach Anspruch 13, **dadurch gekennzeichnet, dass** das Sensorelement einen Teil der Gehäusefläche bildet.

15. Gerät nach einem der Ansprüche 1 bis 14, **dadurch gekennzeichnet, dass** die Sensoranordnung zur Erkennung und Auswertung einer Bewegung des an der Außenseite der Gehäusefläche anliegenden Sensorelements entlang der Gehäusefläche ausgebildet ist.

16. Gerät nach einem der Ansprüche 1 bis 15, **dadurch gekennzeichnet, dass** mit der Sensoranordnung mehrere Betriebsparameter des Geräts veränderlich einstellbar sind.

17. Gerät nach einem der Ansprüche 1 bis 16, **dadurch gekennzeichnet, dass** das Sensorelement in mehrere Teilelemente aufgeteilt ist.

18. Gerät nach Anspruch 17, **dadurch gekennzeichnet, dass** das Steuerelement eine parallel zur Gehäusefläche langgestreckte Form aufweist und die Teilelemente in Längsrichtung des Sensorelements aufeinander folgend angeordnet sind.

19. Gerät nach einem der Ansprüche 1 bis 18, **dadurch gekennzeichnet, dass** wenigstens zwei getrennte Sensorelemente vorhanden sind.

20. Gerät nach Anspruch 19, **dadurch gekennzeichnet, dass** ein erstes Sensorelement zur Auswahl eines von mehreren Betriebsparametern ausgebildet ist und ein zweites Sensorelement zur Veränderung der Einstellung des gewählten Betriebsparameters ausgebildet ist.

21. Gerät nach Anspruch 20, **dadurch gekennzeichnet, dass** das erste und das zweite Sensorelement jeweils eine langgestreckte Form besitzen.

22. Gerät nach einem Anspruch 21, **dadurch gekennzeichnet, dass** das erste und das zweite Sensorelement an verschiedenen Seiten einer Anzeigefläche mit einer Mehrzahl flächig verteilter Anzeigeelemente angeordnet ist.

23. Gerät nach einem der Ansprüche 1 bis 22, **dadurch gekennzeichnet, dass** es sich um ein Steuergerät, insbesondere um einen Bewässerungscomputer handelt.

## Claims

1. Electrically operable gardening device having a switching arrangement which can be manually operated by a user,
in which gardening device the switching arrangement comprises a sensor arrangement (SA) which contains at least one sensor element (SE) which is arranged on a housing surface (GF), wherein the sensor element is designed to identify an opposing element which is applied to the outer face (GA) of the housing surface opposite the sensor element and to which the sensor element is matched, and a switching process can be tripped in the switching arrangement by applying an opposing element to the outer face of the housing surface,
wherein the sensor element is free of mechanical components which can be moved for tripping a switching process,
wherein at least two capacitively measuring sensor elements which each have associated conductor surfaces are provided on the housing surface,
**characterized**
**in that** the at least two sensor elements are designed to select a plurality of variably adjustable operating parameters of the gardening device,
**in that** the sensor arrangement is designed to jointly evaluate sensor signals from a plurality of conductor surfaces,
to which end the switching arrangement or a sensor electronics system is designed to evaluate the time profile of the change in capacitance and to evaluate the geometric distribution of capacitances of the plurality of adjacent conductor surfaces.

2. Device according to Claim 1, **characterized in that** the sensor element is matched to an electrically conductive or a magnetic opposing element.

3. Device according to Claim 1, **characterized in that** the sensor element is matched to a finger of a user as the opposing element and to the electrical conductivity of the finger.

4. Device according to one of Claims 1 to 3, **characterized in that** the sensor arrangement contains at least one substantially flat planar conductor surface as the sensor element.

5. Device according to Claim 4, **characterized in that** the sensor arrangement contains a sensor electronics system which is designed to evaluate the capacitance of the conductor surface.

6. Device according to Claim 4, **characterized in that** the sensor arrangement contains a sensor electronics system which is designed to evaluate the resistance of the sensor element.

7. Device according to one of Claims 4 to 6, **characterized in that** a plurality of conductor surfaces are arranged next to one another as sensor elements, and the sensor electronics system jointly evaluates the sensor signals from adjacent conductor surfaces.

8. Device according to Claim 7, **characterized in that** the mutual distance between adjacent conductor surfaces is smaller than the lateral dimension of the conductor surfaces.

9. Device according to one of Claims 1 to 8, **characterized in that** the at least one sensor element is arranged on a printed circuit board.

10. Device according to one of Claims 1 to 9, **characterized in that** at least one sensor element is arranged behind a closed housing surface which faces the user.

11. Device according to Claim 10, **characterized in that** the housing surface is composed of insulating material.

12. Device according to either of Claims 10 and 11, **characterized in that** the at least one sensor element is printed onto the inner face of the housing surface.

13. Device according to one of Claims 1 to 9, **characterized in that** the sensor element is arranged in the region of a housing aperture.

14. Device according to Claim 13, **characterized in that** the sensor element forms a portion of the housing surface.

15. Device according to one of Claims 1 to 14, **characterized in that** the sensor arrangement is designed to identify and evaluate a movement of the sensor element, which bears against the outer face of the housing surface, along the housing surface.

16. Device according to one of Claims 1 to 15, **characterized in that** the sensor arrangement can be used to variably adjust a plurality of operating parameters of the device.

17. Device according to one of Claims 1 to 16, **characterized in that** the sensor element is divided into a plurality of partial elements.

18. Device according to Claim 17, **characterized in that** the control element has an elongate shape parallel to the housing surface, and the partial elements are arranged in succession in the longitudinal direction of the sensor element.

19. Device according to one of Claims 1 to 18, **characterized in that** there are at least two separate sensor elements.

20. Device according to Claim 19, **characterized in that** a first sensor element is designed to select one of several operating parameters, and a second sensor element is designed to vary the adjustment of the selected operating parameter.

21. Device according to Claim 20, **characterized in that** the first and the second sensor element each have an elongate shape.

22. Device according to Claim 21, **characterized in that** the first and the second sensor element are arranged on different sides of an indicator surface with a plurality of indicator elements which are distributed over the surface.

23. Device according to one of Claims 1 to 22, **characterized in that** the said device is a control device, in particular a watering computer.

## Revendications

1. Appareil de jardinage pouvant être entraîné électriquement, comprenant un arrangement de commutation pouvant être actionné manuellement par un utilisateur,
avec lequel l'arrangement de commutation comprend un arrangement de détection (SA), lequel contient au moins un élément de détection (SE) monté sur une surface de boîtier (GF), l'élément de détection étant configuré pour la détection d'un élément homologue, sur lequel est accordé l'élément de détection, appliqué sur le côté extérieur (GA) de la surface de boîtier en face de l'élément de détection et une opération de commutation pouvant être déclenchée dans l'arrangement de commutation en appliquant un élément homologue sur le côté extérieur de la surface du boîtier,
l'élément de détection étant dépourvu de composants mécaniques mobiles destinées à déclencher une opération de commutation,
au moins deux éléments de détection à mesure capacitive étant prévus sur la surface du boîtier, lesquels présentent des surfaces conductrices respectivement associées,
**caractérisé en ce**
**que** les au moins deux éléments de détection sont exécutés pour sélectionner plusieurs paramètres de fonctionnement réglables de l'appareil de jardinage, que l'arrangement de détection est configuré pour l'interprétation commune des signaux de détection de plusieurs surfaces conductrices,
l'arrangement de commutation ou une électronique de détection étant configuré à cet effet pour interpréter la courbe temporelle de la variation de capacité et pour interpréter la distribution géométrique des capacités des plusieurs surfaces conductrices voisines.

2. Appareil selon la revendication 1, **caractérisé en ce que** l'élément de détection est accordé sur un élément homologue électriquement conducteur ou magnétique.

3. Appareil selon la revendication 1, **caractérisé en ce que** l'élément de détection est accordé sur un doigt d'un utilisateur faisant office d'élément homologue et sur la conductivité électrique du doigt.

4. Appareil selon l'une des revendications 1 à 3, **caractérisé en ce que** l'arrangement de détection contient au moins une surface conductrice sensiblement plane en tant qu'élément de détection.

5. Appareil selon la revendication 4, **caractérisé en ce que** l'arrangement de détection contient une électronique de détection configurée pour l'interprétation de la capacité de la surface conductrice.

6. Appareil selon la revendication 4, **caractérisé en ce que** l'arrangement de détection contient une électronique de détection configurée pour l'interprétation de la résistance de l'élément de détection.

7. Appareil selon l'une des revendications 4 à 6, **caractérisé en ce que** plusieurs surfaces conductrices faisant office d'éléments de détection sont disposées les unes à côté des autres et l'électronique de détection interprète en commun les signaux de détection des surfaces conductrices voisines.

8. Appareil selon la revendication 7, **caractérisé en ce que** l'écart mutuel des surfaces conductrices voisines est plus petit que la dimension transversale des surfaces conductrices.

9. Appareil selon l'une des revendications 1 à 8, **caractérisé en ce que** l'au moins un élément de détection est disposé sur une platine de commutation.

10. Appareil selon l'une des revendications 1 à 9, **caractérisé en ce qu'**au moins un élément de détection est disposé derrière une surface de boîtier fermée faisant face à l'utilisateur.

11. Appareil selon la revendication 10, **caractérisé en ce que** la surface du boîtier se compose de matériau isolant.

12. Appareil selon l'une des revendications 10 ou 11, **caractérisé en ce que** l'au moins un élément de détection est pressé contre le côté intérieur de la surface du boîtier.

13. Appareil selon l'une des revendications 1 à 9, **caractérisé en ce que** l'élément de détection est disposé dans la zone d'une ouverture du boîtier.

14. Appareil selon la revendication 13, **caractérisé en ce que** l'élément de détection forme une partie de la surface du boîtier.

15. Appareil selon l'une des revendications 1 à 14, **caractérisé en ce que** l'arrangement de détection est configuré pour reconnaître et interpréter un mouvement le long de la surface de boîtier de l'élément de détection reposant sur le côté extérieur de la surface de boîtier.

16. Appareil selon l'une des revendications 1 à 15, **caractérisé en ce que** l'arrangement de détection permet de régler de manière modifiable plusieurs paramètres de fonctionnement de l'appareil.

17. Appareil selon l'une des revendications 1 à 16, **caractérisé en ce que** l'élément de détection est divisé en plusieurs éléments partiels.

18. Appareil selon la revendication 17, **caractérisé en ce que** l'élément de commande présente une forme allongée parallèle à la surface de boîtier et les éléments partiels sont disposés successivement dans le sens longitudinal de l'élément de détection.

19. Appareil selon l'une des revendications 1 à 18, **caractérisé en ce qu'**il existe au moins deux éléments de détection séparés.

20. Appareil selon la revendication 19, **caractérisé en ce qu'**un premier élément de détection est configuré pour la sélection d'un parmi plusieurs paramètres de fonctionnement et un deuxième élément de détection est configuré pour la modification du réglage du paramètre de fonctionnement sélectionné.

21. Appareil selon la revendication 20, **caractérisé en ce que** le premier et le deuxième éléments de détection possèdent respectivement une forme allongée.

22. Appareil selon la revendication 21, **caractérisé en ce que** le premier et le deuxième éléments de détection sont disposés sur des côtés différents d'une surface d'affichage comprenant une pluralité d'éléments d'affichage distribués à plat.

23. Appareil selon l'une des revendications 1 à 22, **caractérisé en ce qu'**il s'agit d'un contrôleur, notamment d'un ordinateur d'arrosage.
